# EUROPÄISCHE PATENTANMELDUNG

(11) **EP 4 618 143 A1**
(43) Veröffentlichungstag der Anmeldung: **17.09.2025**
(21) Anmeldenummer: 25162761.8
(22) Anmeldetag: 10.03.2025
(51) Int. Cl.: H01L 23/367, H01L 23/473, H02M 7/00, H05K 7/20, H01L 21/48, H05K 5/06

(54) **POWERMODUL EINES PULSWECHSELRICHTERS, INSBESONDERE ALS TEIL EINER ELEKTRISCHEN FAHRZEUGANTRIEBES, SOWIE VERFAHREN ZUR HERSTELLUNG EINES POWERMODULS**

(30) Priorität: 13.03.2024 DE 102024202350
(71) Anmelder: VOLKSWAGEN AG, 38440 Wolfsburg (DE)
(72) Erfinder: Michelsen, Steffen, 38440 Wolfsburg (DE); Bachmann, Tim, 38440 Wolfsburg (DE); Pieper, Sven, 38440 Wolfsburg (DE)

(57) **Zusammenfassung**

Die Erfindung betrifft ein Powermodul eines Pulswechselrichters, das eine Umhüllung (22) aus Hartguss aufweist, wobei die Umhüllung (22) Teil eines offenen Kühlsystems insoweit ist, als die Umhüllung (22) und/oder eine von der Umhüllung (22) umschlossene Fläche in Kontakt mit Kühlfluid einer Kühlvorrichtung (14) gerät, die an die Umhüllung (22) angrenzend angeordnet ist, wobei an der Umhüllung (22) und/oder an der von der Umhüllung (22) umschlossenen Fläche mindestens ein Dichtelement (12) zur Herstellung einer dichtenden Verbindung zwischen Umhüllung (22) und Kühlvorrichtung (14) formschlüssig und/oder stoffschlüssig fixiert ist. Ferner betrifft die Erfindung ein Verfahren zur Herstellung einer Verbindung zwischen einer Umhüllung (22) eines Powermoduls (10) aus Hartguss und mindestens einem Dichtelement (12) zur Abdichtung der Umhüllung (22) des Powermoduls (10) gegenüber einer offenen Kühlvorrichtung (14) des Powermoduls (10)

## Beschreibung

Die Erfindung betrifft ein Powermodul eines Pulswechselrichters, insbesondere eines Pulswechselrichters, der Teil eines elektrischen Fahrzeugantriebes ist. Ferner betrifft die Erfindung ein Verfahren zur Herstellung eines Powermoduls eines Pulswechselrichters bzw. ein Verfahren zur Herstellung eines Pulswechselrichters. Es wird auf Kraftfahrzeuge mit mindestens einem Powermodul bzw. auf Kraftfahrzeuge mit mindestens einem Pulswechselrichter verwiesen. Mit dem Pulswechselrichter wird die Gleichspannung eines elektrischen Energiespeichers, insbesondere eines elektrischen Antriebsenergiespeichers eines Kraftfahrzeuges, in Wechselspannung zum Betreiben mindestens einer elektrischen Vorrichtung umgewandelt, insbesondere mindestens eines elektrischen Antriebsmotors eines Kraftfahrzeuges.

Aus DE 11 2016 003 982 T5 sind ein Leistungsmodul, eine thermische Dissipationsanordnung des Leistungsmoduls und ein Kontaktierungsverfahren des Leistungsmoduls bekannt. Das Leistungsmodul weist eine Wärmesenke auf, mit der ein Halbleiterchip kontaktiert ist. Ferner ist ein Paket vorgesehen, das dazu ausgebildet ist, einen Umfang des Halbleiterchips abzudichten, um so wenigstens einen Teil der Wärmesenke zu exponieren. Das Leistungsmodul wird durch eine Kühlplatte (Kühleinrichtung) über thermisch-leitfähiges Material kontaktiert. Da Wärme des Leistungsmoduls dissipieren soll, indem die von dem Halbleiterchip erzeugte Wärme von der Wärmesenke zu der Kühleinrichtung über das thermisch-leitfähige Material geleitet wird, handelt es sich um ein geschlossenes Kühlsystem, bei welchem ein etwaiges Kühlmittel (Kühlfluid) in der Kühlplatte bzw. Kühleinrichtung verbleibt. Die Abdichtung eines Übergangs zum Aus- und Einströmen eines Kühlmittels aus der Kühleinrichtung, wie sie bei einem offenen Kühlsystem erforderlich ist, ist insoweit nicht offenbart.

Die aus der Praxis bekannten Pulswechselrichter für den Betrieb elektrischer Traktionsantriebe von Kraftfahrzeugen weisen üblicherweise mehrere Powermodule auf. Diese Powermodule müssen zur Abfuhr der Verlustleistung (insbesondere Wärme) auf einem Kühler oder einer sonstigen Wärmesenke montiert werden. Bei der Direktmontage auf einem Kühler (offenes Kühlsystem) erfolgt dies bei aus der Praxis bekannten Vorrichtungen derart, dass die Unterseite des umhüllten Moduls mit einer Strömungsleit- / Wärmeableitgeometrie (sogenannte "Pin-Fins") versehen ist und diese in direktem Kontakt zum Kühlmedium montiert werden. Hierbei muss im Rahmen der Montage eine mediendichte Verbindung zwischen Powermodul und Kühler hergestellt werden. Zur Abdichtung werden Dichtringe (meist sogenannte O-Ringe) eingesetzt, die in vorgefertigten Aufnahmegeometrien (z.B. einer umlaufenden Nut) eingesetzt werden. Diese werden dann beim Montieren des Kühlers, beispielsweise mittels Schrauben, dichtend angepresst. Aus der Praxis ebenfalls bekannt ist es, statt eines Dichtringes oder ergänzend dazu Flächendichtmittel einzusetzen und/oder den Kühler mit dem Powermodul durch Löten stoffschlüssig dichtend zu verbinden.

Nachteilig an den aus der Praxis bekannten Konstruktionen mit Dichtring ist der hohe Montageaufwand sowie die Fehleranfälligkeit beim Montieren bzw. Platzieren eines Dichtrings. Diesbezüglich besteht zum einen die Gefahr, dass der Dichtring nicht über den gesamten Umfang korrekt vorpositioniert wird, indem er teilweise nicht in der Nut angeordnet ist. Zum anderen kann der Dichtring bis zur Montage auch nach korrektem Vorpositionieren noch unbeabsichtigt verschoben oder anderweitig vollständig oder partiell aus seiner Position bewegt werden. Da die korrekte Positionierung des Dichtrings nach der Montage des Powermoduls nicht mehr einsehbar ist, ist eine nachgelagerte Montagekontrolle nicht möglich.

Nachteilig an der Verwendung des aus der Praxis bekannten Flächendichtmittels und an den stoffschlüssigen Verfahren ist, dass diese einen großen Platzbedarf aufweisen, so dass entweder das kostenintensive Substratmaterial des Powermoduls gegenüber den elektrischen Anforderungen überdimensioniert oder eine zusätzliche Wärmeverteilplatte verbaut werden muss. Bei Verbau einer zusätzlichen Wärmeverteilplatte besteht der weitere Nachteil, dass dies den thermischen Durchgangswiderstand zwischen Wärmequelle (Chip des Powermoduls) und Wärmesenke (Kühlmedium) negativ beeinflusst.

Der Erfindung liegt die Aufgabe zugrunde, ein Powermodul eines Pulswechselrichters sowie ein Verfahren zur Herstellung eines Powermoduls zur Verfügung zu stellen, welche eine sichere Montage ermöglichen.

Die Lösung der Aufgabe erfolgt erfindungsgemäß mit den Merkmalen der unabhängigen Ansprüche. Weitere praktische Ausführungsformen und Vorteile der Erfindung sind in Verbindung mit den abhängigen Ansprüchen beschrieben.

Ein erfindungsgemäßes Powermodul eines Pulswechselrichters umfasst eine Umhüllung aus Hartguss (Hartgussumhüllung). Unter einer solchen Hartgussumhüllung wird insbesondere eine Umhüllung aus einem duroplastischen Material oder aus einem keramischen Material verstanden. Die Umhüllung ist Teil eines offenen Kühlsystems insoweit, als die Umhüllung und/oder eine von der Umhüllung umschlossene Fläche in Kontakt mit Kühlfluid einer Kühlvorrichtung gerät, die an die Umhüllung angrenzend angeordnet ist. Dabei ist an der Umhüllung oder der von der Umhüllung umschlossenen Fläche mindestens ein Dichtelement zur Herstellung einer dichtenden Verbindung zwischen Umhüllung und Kühlvorrichtung formschlüssig und/oder stoffschlüssig fixiert. Das erfindungsgemäße Powermodul hat damit den Vorteil, dass die Umhüllung oder eine von der Umhüllung umschlossene Fläche genutzt wird, um ein Dichtelement vor zu positionieren. Das Risiko, dass das Dichtelement nachträglich verrutscht oder anderweitig verschoben wird, ist damit nahezu ausgeschlossen, so dass eine dichtende Verbindung zwischen der Umhüllung und der Kühlvorrichtung mit hoher Funktionssicherheit gelingt.

In einer praktischen Ausführungsform eines erfindungsgemäßen Powermoduls ist das mindestens eine Dichtelement durch Einlegen in die Gießform und Umgießen mit der Umhüllung aus Hartguss mindestens stoffschlüssig fixiert. In diesem Fall wird die Umhüllung selbst genutzt, um ein Festlegen des Dichtelements zu bewirken. Abgesehen davon, dass das Dichtelement in die Gießform einzulegen ist, sind keine zusätzlichen Verfahrensschritte oder Hilfsmittel erforderlich, um das Vorfixieren des Dichtelements zu bewirken. Damit kann das Vorfixieren des Dichtelements nahezu ohne Zusatzkosten realisiert werden.

In einer weiteren praktischen Ausführungsform weist das mindestens eine Dichtelement eine Hinterschneidung in eine Richtung senkrecht zur Dichtebene auf, wodurch beim Umgießen eine zusätzlich formschlüssige Verbindung zwischen dem mindestens einen Dichtelement und der Umhüllung gebildet ist. In diesem Fall kann die Sicherung des Dichtelements gegenüber der Umhüllung zusätzlich erhöht werden, da kein Lösen des Dichtelements zusätzlich formschlüssig gesichert ist.

In einer alternativen Ausführungsform eines erfindungsgemäßen Powermoduls ist das mindestens eine Dichtelement durch Anvulkanisieren an die Umhüllung aus Hartguss mindestens stoffschlüssig fixiert. In diesem Fall wird der Herstellungsprozess des Dichtelements selbst genutzt, um das Dichtelement gegenüber der Umhüllung vor zu fixieren. Die vorstehend angesprochenen Vorteile, gemäß welchen auf zusätzliche Hilfsmittel verzichtet werden kann, gelten auch für diese Ausführungsform.

In einer weiteren praktischen Ausführungsform eines erfindungsgemäßen Powermoduls ist das mindestens eine Dichtelement aus einem reibschweißgeeigneten Werkstoff ausgebildet, wobei die Kühlvorrichtung aus einem komplementär reibschweißgeeigneten Werkstoff ausgebildet ist. In diesem Fall kann das Dichtelement auf einfache Art und Weise durch Reibschweißen dichtend mit der Kühlvorrichtung verbunden werden, insbesondere indem das Dichtelement aus dem reibschweißgeeigneten Werkstoff mittels Reibschweißen mit der Kühlvorrichtung aus dem komplementär reibschweißgeeigneten Werkstoff mittels Reibschweißen verbunden wird. In diesem Zusammenhang wird insbesondere auf Dichtelemente aus einem Kunststoff verwiesen, insbesondere aus einem thermoplastischen Kunststoff.

Wenn das mindestens eine Dichtelement aus dem gleichen Werkstoff ausgebildet ist wie die Kühlvorrichtung, kann eine dichtende Verbindung zwischen dem Dichtelement und der Kühlvorrichtung auch auf einfache Art und Weise durch Kleben gebildet werden. Dies gilt insbesondere für ein Dichtelement und eine Kühlvorrichtung aus Metall, insbesondere aus Aluminium. In diesem Fall kann eine hochfeste Klebeverbindung durch Ankleben des Dichtelements aus Aluminium an der Kühlvorrichtung aus Aluminium hergestellt werden.

Wenn mindestens ein weiteres Dichtelement vorgesehen ist, das unabhängig von dem mindestens einen Dichtelement zur Abdichtung zwischen Umhüllung und Kühlvorrichtung angeordnet ist, kann die Sicherheit eines erfindungsgemäßen Powermoduls in Bezug auf die Dichtheit zu der Kühlvorrichtung weiter erhöht werden. In diesem Fall bleibt die Verbindung zwischen Umhüllung und Kühlvorrichtung auch dann dicht, wenn eines der Dichtelemente versagen sollte.

Die Erfindung betrifft auch ein Verfahren zur Herstellung einer Verbindung zwischen einer Umhüllung eines Powermoduls aus Hartguss und mindestens einem Dichtelement zur Abdichtung der Umhüllung des Powermoduls gegenüber einer offenen Kühlvorrichtung des Powermoduls. Hinsichtlich der Definition einer offenen Kühlvorrichtung wird auf das Vorstehende verwiesen. Gemäß dem erfindungsgemäßen Verfahren wird mit dem Vorgang des Umhüllens des Powermoduls mindestens ein Dichtelement formschlüssig und/oder kraftschlüssig an der Umhüllung festgelegt, oder die Umhüllung und/oder eine von der Umhüllung umschlossene Fläche des Powermoduls wird für eine nachträgliche stoffschlüssige und/oder formschlüssige Vorfixierung des mindestens einen Dichtelements genutzt. Auf die vorstehend bereits in Verbindung mit dem erfindungsgemäßen Powermodul erläuterten Vorteile wird hiermit noch einmal verwiesen.

In einer praktischen Ausführungsform des erfindungsgemäßen Verfahrens wird das mindestens eine Dichtelement in eine Gießform zur Herstellung der Umhüllung eingelegt, und beim Herstellen der Umhüllung wird das Dichtelement von der Umhüllung teilweise umgossen und somit umschlossen.

Gemäß einer weiteren praktischen Ausführungsform des erfindungsgemäßen Verfahrens wird das mindestens eine Dichtelement an die Umhüllung und/oder an die von der Umhüllung umschlossene Fläche anvulkanisiert, das mindestens eine Dichtelement in eine an der Umhüllung ausgebildete Vertiefung eingepresst und/oder das mindestens eine Dichtelement mittels Reibschweißen an der Umhüllung fixiert. In allen Fällen wird der Herstellungsprozess der Umhüllung und/oder der Herstellungsprozess des Dichtelements bzw. die Werkstoffpaarung genutzt, um das Dichtelement vor der Verbindung des Powermoduls mit der Kühlvorrichtung an der Umhüllung zu fixieren. Ein Verrutschen oder Verschieben des Dichtelements vor oder während der Montage von Kühlvorrichtung und Powermodul wird so sicher verhindert.

Der Vollständigkeit halber wird noch darauf hingewiesen, dass die nachfolgend in Verbindung mit den Figuren beschriebenen Ausführungsbeispiele nur beispielhaft sind. Auf die Zahl und Form der Pin-Fin, die Form des Substrats, die Zahl der Chips, die Zahl der Kontakte, die geometrische Gestaltung des Substrats und weitere Einzelmerkmale kommt es grundsätzlich nicht an, solange der Wortlaut der Ansprüche realisiert ist. Das gleiche gilt für die konkrete Formgebung des Dichtelements sowie die Positionierung von Hinterschneidungen.

Weitere praktische Ausführungsformen der Erfindung sind nachfolgend im Zusammenhang mit den Zeichnungen beschrieben. Es zeigen:
- Fig. 1: eine Anordnung von drei Powermodulen an einem Kühler mit nicht montierten Dichtelementen in einer Explosionsdarstellung,
- Fig. 2: die Anordnung aus Fig. 1 im montierten Zustand,
- Fig. 3: ein einzelnes Powermodul ohne Umhüllung in einer isometrischen Ansicht von schräg oben,
- Fig. 4: das Powermodul aus Figur 3 mit Umhüllung in einer Ansicht von unten,
- Fig. 5: eine erste Ausführungsform eines erfindungsgemäßen Powermoduls mit form- und stoffschlüssig fixiertem Dichtelement aus einem Elastomer-Material in einer Schnittdarstellung,
- Fig. 6: eine weitere Ausführungsform eines erfindungsgemäßen Powermoduls mit einem Dichtelement in Form einer Elastomer-Dichtung, welche an die Umhüllung anvulkanisiert ist,
- Fig. 7: eine weitere Ausführungsform eines erfindungsgemäßen Powermoduls mit einem Dichtelement in Form einer Thermoplast-Schnittstelle, die formschlüssig und stoffschlüssig an die Umhüllung angebunden ist,
- Fig. 8: eine weitere Ausführungsform eines erfindungsgemäßen Powermoduls mit einem Dichtelement in Form eines Metalleinlegers, der stoffschlüssig an der Umhüllung festgelegt ist und
- Fig. 9-11: drei Verfahrensschritte eines erfindungsgemäßen Verfahrens zur Herstellung einer Verbindung zwischen einer Umhüllung eines Powermoduls aus Hartguss und mindestens einem Dichtelement.

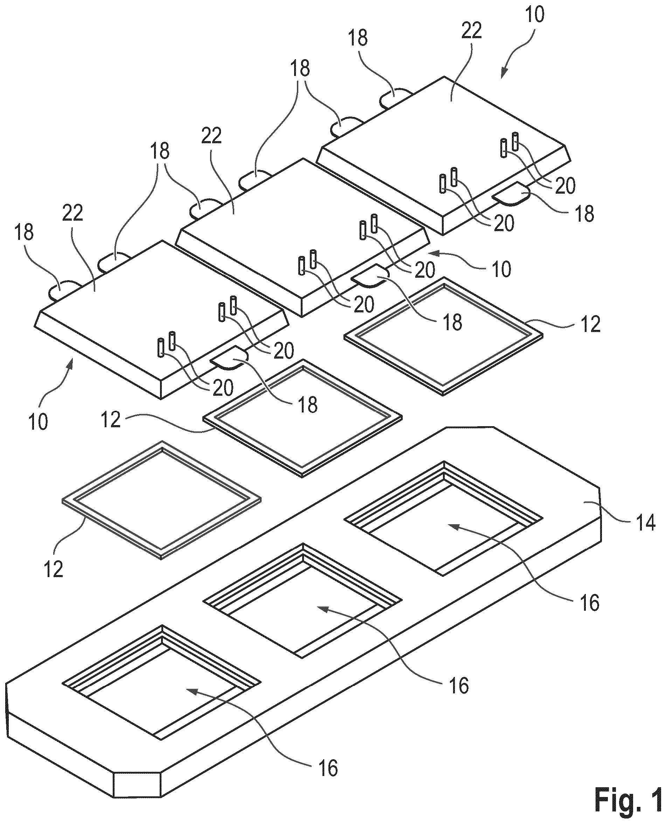

Figur 1 zeigt eine Ausführungsform von drei Powermodulen 10, die mit drei korrespondierenden Dichtelementen 12 dichtend an einer Kühlvorrichtung 14 angeordnet werden sollen. Die Kühlvorrichtung 14 weist dazu korrespondierende Vertiefungen 16 auf, welche im montierten Zustand von Kühlfluid (nicht gezeigt) durchströmt sind.

Aus jedem Powermodul 10 ragen jeweils seitlich drei Kontakte 18 heraus, wobei ein Kontakt 18 einseitig und gegenüberliegend zwei Kontakte 18 angeordnet sind. Diese Ausführungsform ist beispielhaft. Alternativ können insbesondere auch drei Kontakte auf einer Seite und zwei Kontakte auf der gegenüberliegenden Seite vorgesehen sein (nicht dargestellt). Auf weitere Möglichkeiten zur Zahl der aus dem Powermodul herausragenden Kontakte wir ebenfalls verwiesen.

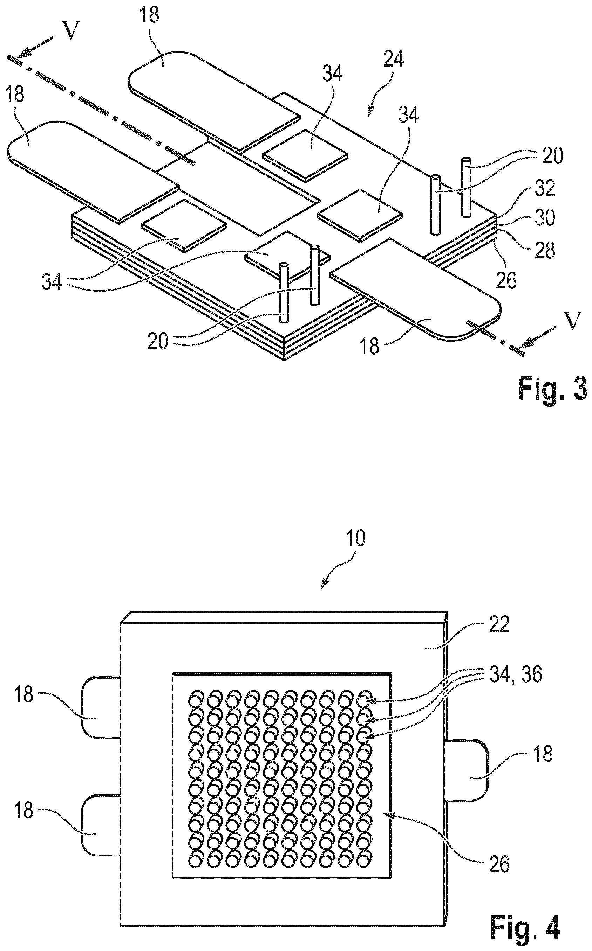

Oberseitig ragen aus jedem dargestellten Powermodul vier Controlpins 20 heraus. Die Zahl dieser Controlpins ist ebenfalls beispielhaft und in der Praxis variabel. Der innere Aufbau der Powermodule 10 ist von einer Umhüllung 22 verdeckt. Wie ein Powermodul 10 ohne die Umhüllung 22 aufgebaut sein kann, ist in Figur 3 gezeigt. In der in Figur 3 gezeigten Ausführungsform ist erkennbar, dass das Innere des Powermoduls 10 im Wesentlichen gebildet ist aus einem Substrat 24, das gebildet ist aus einer unteren, metallischen Platte 26 (insbesondere aus Aluminium oder einem anderen Metall) mit Kühlstruktur (z.B. Pin-Fins), einer darüber angeordneten, elektrisch leitfähigen Schicht, hier einer Kupferschicht 28, einer darüber angeordneten elektrisch isolierenden Schicht, hier einer Keramikschicht 30 und einer darüber angeordneten elektrisch leitfähigen Schicht, hier einer Kupferschicht 32. Auf der oberen Kupferschicht 32 sind vier Chips 34 aufgebracht.

Figur 4 zeigt die Unterseite eines Powermoduls 10 mit Umhüllung 22. Dort ist erkennbar, dass an der unteren Platte 26 eine Vielzahl von Strömungsleitstrukturen 34 in Form von Pin-Fins 36 ausgebildet sind. Dies sind in der gezeigten Ausführungsform kleine zylindrische Vorsprünge, die senkrecht aus der metallischen unteren Platte 26 nach unten herausragen. In der gezeigten Ausführungsform weist die untere Platte 26 eine quadratische Grundform auf, wobei über die Fläche insgesamt 100 Pin-Fins 36 angeordnet sind. Im montierten Zustand mit der Kühlvorrichtung 14 werden die Pin-Fins 36 von Kühlfluid umströmt und sorgen so für eine verbesserte Wärmeübertragung von der unteren Platte 26 in das Kühlfluid, da durch die Pin-Fins 36 eine vergrößerte Oberfläche zum Kontakt 18 mit dem Kühlfluid zur Verfügung gestellt wird.

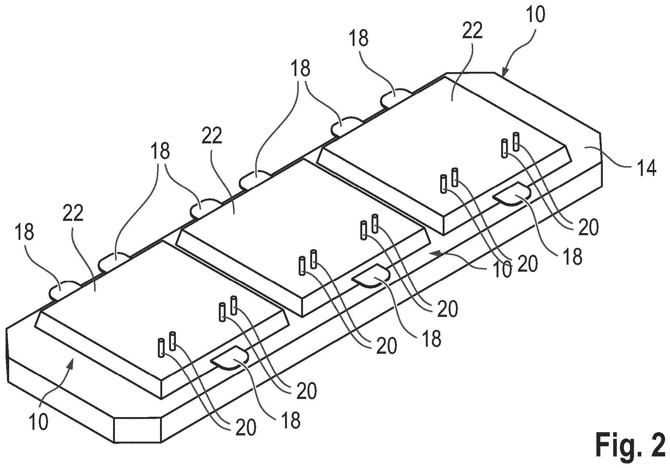

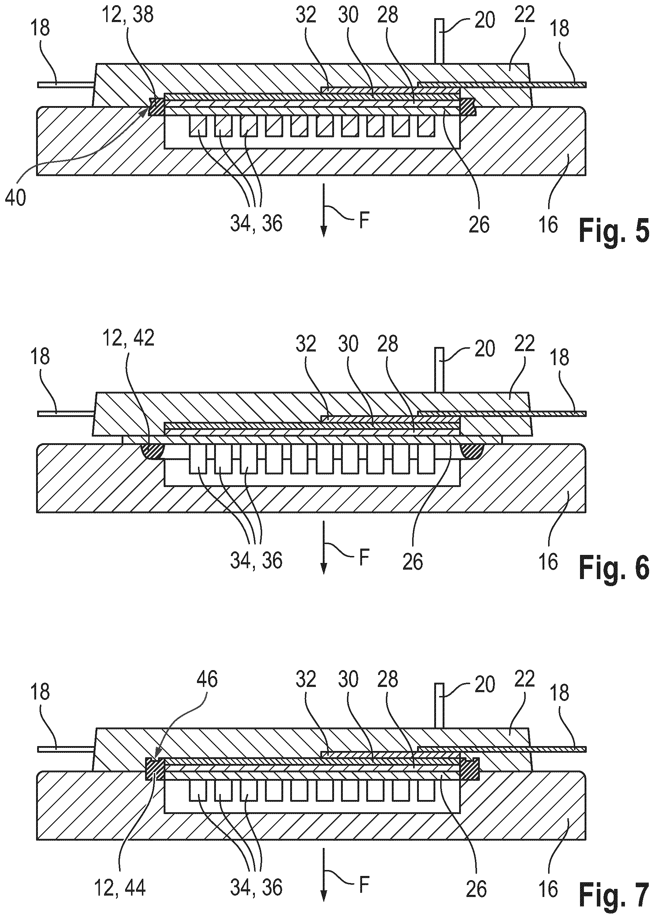

In den Figuren 5 bis 8 sind vier verschiedene Ausführungsformen erfindungsgemäßer Powermodule 10 in einer Schnittdarstellung gemäß der Linie V-V in Figur 3 gezeigt. Soweit nicht anders beschrieben, sind identische oder zumindest funktionsgleiche Elemente mit den gleichen Bezugszeichen wie in den Figuren 1 bis 4 versehen.

Bei der in Figur 5 gezeigten Ausführungsform ist als Dichtelement 12 eine Elastomer-Dichtung 38 vorgesehen. Die Elastomer-Dichtung 38 weist radial außenseitig eine Hinterschneidung 40 auf, welche in der gezeigten Ausführungsform dadurch ausgebildet ist, dass sich die Elastomer-Dichtung 38 von unten nach oben betrachtet zunächst linear verjüngt und dann wieder binär verbreitert. Dadurch wird die Elastomer-Dichtung 38 beim Umspritzen des Substrats 24 mit der Umhüllung 22 sowohl stoffschlüssig als auch formschlüssig gegenüber der Umhüllung 22 fixiert. Dabei ist der Formschluss in Richtung des Pfeils F erzielt. Ein Herausziehen des Dichtelements 12 wäre nur durch teilweise Zerstörung der Umhüllung 22 möglich.

Bei der in Figur 6 gezeigten Ausführungsform ist als Dichtelement 12 eine Elastomer-Dichtung 42 vorgesehen. Diese Elastomer-Dichtung 42 ist unterseitig an die untere Platte 26 anvulkanisiert. Die Elastomer-Dichtung 42 ragt daher mit ihrer vollen Höhe gegenüber der unteren Platte 26 nach unten hervor.

Bei die in Figur 7 gezeigten Ausführungsform ist als Dichtelement 12 eine Thermoplast-Schnittstelle 44 vorgesehen. Die Thermoplast-Schnittstelle 44 weist oberseitig eine Hinterschneidung 46 auf und ist damit nicht nur stoffschlüssig an der Umhüllung 22 fixiert, sondern auch in Richtung des Pfeils F formschlüssig an der Umhüllung 22 festgelegt. Der Formschluss durch die Hinterschneidung 46 ergibt sich dadurch, dass an der Thermoplast-Schnittstelle 44 oberseitig eine Öffnung vorgesehen ist, die sich von oben nach unten aufweitet, so dass beim Umgießen des Substrats 24 mit der Umhüllung 22 Material der Umhüllung 22 in diese Öffnung einströmt. Nach dem Aushärten der Umhüllung 22 kann die Thermoplast-Schnittstelle 44 in Richtung des Pfeils F nur herausgezogen werden, indem die Umhüllung 22 im Bereich der Hinterschneidung 46 teilweise zerstört wird. Dadurch ergibt sich der Formschluss in Richtung des Pfeils F.

Vorzugsweise wird die Thermoplast-Schnittstelle 44 kombiniert mit einer Kühlvorrichtung 14, die ebenfalls aus einem thermoplastischen Werkstoff gebildet ist oder aus einem Werkstoff, die zusammen mit der Thermoplast-Schnittstelle 44 reibschweißgeeignet ist. In diesem Fall kann die Abdichtung der Umhüllung 22 gegenüber der Kühlvorrichtung 14 durch Reibschweißen erfolgen, indem eine Reibschweißverbindung zwischen der Thermoplast-Schnittstelle 44 und der Kühlvorrichtung 14 hergestellt wird.

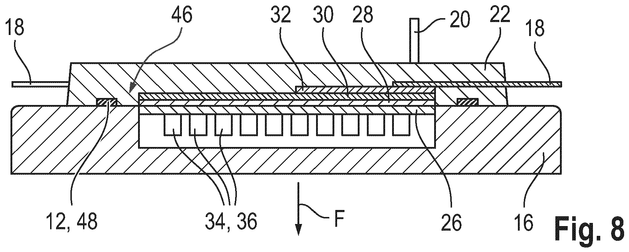

Figur 8 zeigt eine Ausführungsform, bei welcher als Dichtelement 12 ein Aluminiumeinleger 48 vollständig in der Umhüllung 22 angeordnet ist. Dabei ist der Aluminiumeinleger 48 flächenbündig zu der Umhüllung 22 angeordnet. Diese Ausführungsform wird vorzugsweise mit einer Kühlvorrichtung 14 aus Aluminium kombiniert, so dass durch Verkleben des Aluminiumeinlegers 48 mit der Kühlvorrichtung 14 aus Aluminium eine vorteilhafte und dichte Klebeverbindung hergestellt werden kann. Alternativ kann die Kühlvorrichtung 14 auch aus einem anderen Material hergestellt sein, welches sich gut mit dem Aluminiumeinleger 48 verkleben lässt. Alternativ kann auch anstelle eines Aluminiumeinlegers 48 ein Einleger aus einem anderen Werkstoff (nicht dargestellt) eingesetzt werden, um eine vorteilhafte Klebepaarung zwischen dem Dichtelement 12 und der Kühlvorrichtung 14 zu erzielen.

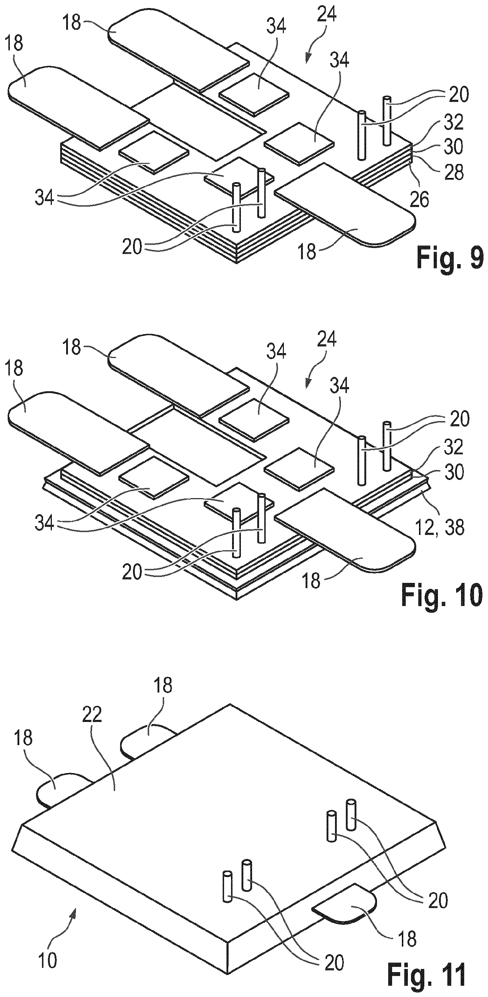

In den Figuren 9 bis 11 ist ein Verfahren zur Herstellung einer Verbindung zwischen einer Umhüllung 22 eines Powermoduls 10 aus Hartguss und mindestens einem Dichtelement 12 zur Abdichtung der Umhüllung 22 des Powermoduls 10 gegenüber einer offenen Kühlvorrichtung 14 des Powermoduls 10 gezeigt.

Figur 9 zeigt zunächst ein Substrat 24, wie es in Verbindung mit Figur 3 bereits erläutert worden ist. In einem ersten Verfahrensschritt wird das Substrat 24 zusammen mit einem Dichtelement 12, hier in Form der in Figur 5 gezeigten Elastomer-Dichtung 38, in eine nicht dargestellte Gießform eingelegt. Anschließend wird in einem weiteren Verfahrensschritt durch Umgießen des Substrats 24 und Angießen des Dichtelements 12 die Umhüllung 22 erzeugt, wie sie in Figur 11 dargestellt ist. Daraus resultiert die Anordnung, welche in Figur 5 in einer Schnittdarstellung gemäß der Linie V-V in Figur 3 dargestellt ist.

Die in der vorliegenden Beschreibung, in den Zeichnungen sowie in den Ansprüchen offenbarten Merkmale der Erfindung können sowohl einzeln als auch in beliebigen Kombinationen für die Verwirklichung der Erfindung in ihren verschiedenen Ausführungsformen wesentlich sein. Die Erfindung kann im Rahmen der Ansprüche und unter Berücksichtigung der Kenntnisse des zuständigen Fachmanns variiert werden.

### Bezugszeichenliste

- 10: Powermodul
- 12: Dichtelement
- 14: Kühlvorrichtung
- 16: Vertiefung
- 18: Kontakt
- 20: Controlpin
- 22: Umhüllung
- 24: Substrat
- 26: untere Platte (metallisch)
- 28: Kupferschicht
- 30: Keramikschicht
- 32: Kupferschicht
- 34: Chip
- 36: Strömungsleitstruktur (Pin-Fin)
- 38: Elastomer-Dichtung
- 40: Hinterschneidung
- 42: Elastomer-Dichtung
- 44: Thermoplast-Schnittstelle
- 46: Hinterschneidung
- 48: Aluminiumeinleger

## Patentansprüche

1. Powermodul eines Pulswechselrichters, das eine Umhüllung (22) aus Hartguss aufweist, wobei die Umhüllung (22) Teil eines offenen Kühlsystems insoweit ist, als die Umhüllung (22) und/oder eine von der Umhüllung (22) umschlossene Fläche in Kontakt mit Kühlfluid einer Kühlvorrichtung (14) gerät, die an die Umhüllung (22) angrenzend angeordnet ist,
**dadurch gekennzeichnet,**
**dass** an der Umhüllung (22) und/oder an der von der Umhüllung (22) umschlossenen Fläche mindestens ein Dichtelement (12) zur Herstellung einer dichtenden Verbindung zwischen Umhüllung (22) und Kühlvorrichtung (14) formschlüssig und/oder stoffschlüssig fixiert ist.

2. Powermodul nach dem vorstehenden Anspruch, **dadurch gekennzeichnet, dass** das mindestens eine Dichtelement (12) durch Einlegen in die Gießform und Umgießen mit der Umhüllung (22) aus Hartguss mindestens stoffschlüssig fixiert ist.

3. Powermodul nach dem vorstehenden Anspruch, **dadurch gekennzeichnet, dass** das mindestens eine Dichtelement (12) eine Hinterschneidung (40) in einer Richtung senkrecht zur Dichtebene aufweist, wodurch beim Umgießen eine zusätzlich formschlüssige Verbindung zwischen dem mindestens einen Dichtelement (12) und der Umhüllung (22) gebildet ist.

4. Powermodul nach einem der vorstehenden Ansprüche, **dadurch gekennzeichnet, dass** das mindestens eine Dichtelement (12) durch Anvulkanisieren an die Umhüllung (22) aus Hartguss und/oder an die von der Umhüllung (22) umschlossene Fläche mindestens stoffschlüssig fixiert ist.

5. Powermodul nach einem der vorstehenden Ansprüche, **dadurch gekennzeichnet, dass** das mindestens eine Dichtelement (12) aus einem reibschweißgeeigneten Werkstoff ausgebildet ist, wobei die Kühlvorrichtung (14) aus einem komplementär reibschweißgeeigneten Werkstoff ausgebildet ist.

6. Powermodul nach einem der vorstehenden Ansprüche, **dadurch gekennzeichnet, dass** das mindestens eine Dichtelement (12) aus dem gleichen Werkstoff ausgebildet ist wie die Kühlvorrichtung (14).

7. Powermodul nach einem der vorstehenden Ansprüche, **dadurch gekennzeichnet, dass** mindestens ein weiteres Dichtelement (12) vorgesehen ist, das unabhängig dem mindestens einen Dichtelement zur Abdichtung zwischen Umhüllung (22) und Kühlvorrichtung (14) angeordnet ist.

8. Verfahren zur Herstellung einer Verbindung zwischen einer Umhüllung (22) eines Powermoduls (10) aus Hartguss und mindestens einem Dichtelement (12) zur Abdichtung der Umhüllung (22) des Powermoduls (10) gegenüber einer offenen Kühlvorrichtung (14) des Powermoduls (10),
**dadurch gekennzeichnet,**
**dass** mit dem Vorgang des Umhüllens des Powermoduls (10) mindestens ein Dichtelement (12) formschlüssig und/oder kraftschlüssig an der Umhüllung (22) festgelegt wird oder die Umhüllung (22) und/oder eine von der Umhüllung (22) umschlossene Fläche des Powermoduls (10) für eine nachträgliche stoffschlüssige und/oder formschlüssige Vorfixierung des mindestens einen Dichtelements (12) genutzt wird.

9. Verfahren nach dem vorstehenden Anspruch, **dadurch gekennzeichnet, dass** das mindestens eine Dichtelement (12) in eine Gießform zur Herstellung der Umhüllung (22) eingelegt und beim Herstellen der Umhüllung (22) teilweise von der Umhüllung (22) umgossen und somit umschlossen wird.

10. Verfahren nach einem der beiden vorstehenden Ansprüche, **dadurch gekennzeichnet, dass** das mindestens eine Dichtelement (12) an die Umhüllung (22) und/oder an die von der Umhüllung (22) umschlossene Fläche anvulkanisiert wird, das mindestens eine Dichtelement (12) in eine an der Umhüllung (22) ausgebildete Vertiefung (16) eingepresst wird und/oder das mindestens eine Dichtelement (12) mittels Reibschweißen an der Umhüllung (22) fixiert wird.
